# DEMANDE DE BREVET EUROPEEN

(11) **EP 2 104 145 A1**
(43) Date de publication de la demande: **23.09.2009**
(21) Numéro de dépôt: 08152955.4
(22) Date de dépôt: 18.03.2008
(51) Int. Cl.: H01L 31/0224

(54) **Substrat de type verrier revêtu de couches minces et procédé de fabrication**

(71) Demandeur: AGC Flat Glass Europe SA, 1170 Bruxelles (BE)
(72) Inventeur: Coster, Dominique AGC Flat Glass Europe S.A., 6040, Jumet (BE); Schutz, Alain, 5190, Moustier (BE); Jacot, Pieter, 5190, Moustier (BE); Ruelle, Jean-François, 5190, Moustier (BE); Dognies, Xavier, 5190, Moustier (BE); Decroupet, Daniel AGC Flat Glass Europe S.A., 6040, Jumet (BE)
(74) Mandataire: Vandeberg, Marie-Paule L.G.

(57) **Abrégé**

Il est décrit un substrat transparent de type verrier revêtu d'un empilage de couches minces, constituant en particulier un substrat conducteur pour cellules solaires, en particulier pour cellules photovoltaïques, ainsi qu'un procédé de fabrication d'un tel substrat.

L'empilage de couches minces comporte au moins
- une couche conductrice dont l'épaisseur est comprise entre 200 et 1000 nm
- une couche supérieure dont l'indice de réfraction est compris entre 1.45 et 2.2 et dont l'épaisseur est comprise entre 5 et 300 nm.

Le substrat et l'empilage sont tels que la valeur de Transmission entre 450 et 850 nm moins le haze est supérieure à 70 %, voire 75%.

Les substrats décrits combinent de manière surprenante des propriétés électriques et optiques contradictoires : une conductivité électrique élevée, la présente d'une couche tampon et une transmission lumineuse et solaire élevée.

## Description

La présente invention concerne un substrat transparent de type verrier revêtu d'un empilage de couches minces, constituant en particulier un substrat conducteur pour cellules solaires, en particulier pour cellules photovoltaïques. La présente invention concerne aussi un procédé de fabrication d'un tel substrat.

On connaît des substrats de type verrier revêtus de couches conductrices transparentes (basse émissive (« low e »), anti-statique). Par exemple, des couches à base d'ITO, d'oxyde de zinc dopé, ou d'oxyde d'étain dopé (antimoine ou fluor) sont bien connues pour leurs propriétés de conductivité électrique.
D'autre part, les cellules solaires à base de couches minces, sont généralement composées de deux couches conductrices ou électrodes encapsulant un empilage de couches formant la cellule de photoconversion. Une au moins des deux électrodes doit être transparente et est communément appelée TCO « Transparent Conducting Oxide ». L'électrodre transparente est déposée sur un substrat en verre permettant de protéger l'ensemble des couches.

Il existe notamment des cellules de photoconversion à base de silicium amorphe, à base de silicium microcristallin ou à base de tellure de cadmium. Dans ce dernier cas, une couche de sulfure de cadmium est généralement intercalée entre l'électrode transparente et la couche de tellure de cadmium.

Pour fournir un substrat de type verrier, revêtu d'une couche conductrice apte à servir d'électrode sur laquelle la cellule de photoconversion peut être déposée, il faut combiner les propriétés de conductivité élevée et des propriétés optiques particulières permettant à la cellule de photoconversion de recevoir le maximum d'énergie solaire.

Or ces propriétés sont contradictoires, pour augmenter la conductivité, il est nécessaire d'augmenter l'épaisseur de la couche conductrice, ce qui a pour conséquence de diminuer la transmission lumineuse et d'augmenter le haze. La diminution de la transmission lumineuse diminue la quantité d'énergie solaire atteignant la cellule de photoconversion.

Il est connu que les couches à base d'oxyde d'étain déposées par pyrolyse sur le verre (en phase vapeur (CVD), en phase liquide (pulvérisation) ou en phase solide (pulvérisation de poudre) donnent généralement un voile blanchâtre appelé « haze ». Ce voile est principalement le résultat de la diffusion de la lumière (light scattering) à l'interface irrégulière entre la couche d'oxyde d'étain et le milieu d'où provient le rayonnement incident.

Dans certains cas, un haze élevé est recherché pour augmenter l'effet de « light scattering ». Dans le document EP 1 056 136, il est proposé d'augmenter le haze en fournissant une structure :
verre / Sn02 / Si02 / Sn02 :F / structure de photoconversion (Si) / électrode arrière
où la couche Sn02 comporte des trous, de manière à obtenir des irrégularités à la surface de la couche conductrice. Un haze de 7.5 à 11 % est ainsi obtenu.

Dans les documents W02006/121601 & W02007/106226, il est également proposé d'augmenter l'effet de « light scattering » en fournissant une structure :
verre extra-clair/ ZnO pour cellule solaire,
où la surface du substrat en verre peut être rendue irrégulière (« patterned »).

On connaît également des structures pour cellules solaires comportant :
un substrat de type verrier / une couche conductrice (Cd₂SnO₄ ou SnO₂ : F, ...) / une couche tampon / CdS / CdTe /électrode arrière.

La couche tampon, de faible conductivité, permet d'augmenter l'efficacité de la cellule en permettant la diminution de l'épaisseur de la couche CdS. Il est en effet intéressant de minimiser la couche de CdS, à cause de son absorption qui empêche la lumière d'atteindre le CdTe. L'utilisation d'une couche électriquement isolante entre la couche conductrice et le la couche CdS permet d'éviter les contacts entre la couche conductrice et le CdTe.

Dans le document WO 00/14812, il est décrit une structure :
Verre / Cd₂SnO₄ / Zn₂SnO₄ (20-300 nm) / CdS / CdTe.

Dans ce document, aucune indication n'est donnée sur l'épaisseur de la couche conductrice, ni sur les implications de cette épaisseur sur la transmission lumineuse et solaire de l'empilage et sur les propriétés conductrices requises.

Dans les documents WO 93/14524 & WO 95/03630, il est décrit une structure :
Verre /éventuellement couche barrière au Na+ /SnO₂:F (0.4-1µ) /SnO₂ /CdS /CdTe.

La couche tampon telle que décrite doit être de faible conductivité (1.25 10⁻³ à 100 mho/cm), est de préférence à base de Sn02 et a une épaisseur de 0.8 µm.

Il a été découvert qu'une couche d'une telle épaisseur a l'inconvénient de diminuer la transmission lumineuse et solaire et d'augmenter le haze. L'efficacité de la cellule solaire est donc affectée par cette couche tampon. De plus, l'épaisseur élevée de la couche tampon a un effet négatif sur la durabilité de l'empilage. Plus l'épaisseur des couches augmentent, plus les tensions augmentent. En particulier, lorsque la couche est soumise à un stress mécanique ou chimique (humidité entre autre), la couche épaisse pourrait avoir tendance à se délaminer. Une telle couche est également difficile à déposer car elle nécessite un flux important de réactifs. Etant donné que la vitesse du verre (sous le coater) atteint 10-15m/min voire plus, il a été découvert qu'il est particulièrement difficile de déposer une telle couche avec peu de haze.

Dans WO 93/14524, la couche tampon à base de Sn02 doit être dopée avec un élément dopant (Zn, In, Ga, Al) différent du dopant de la couche conductrice. Le dopage du Sn02 avec ces éléments est particulièrement compliqué et aucun procédé industriel n'est disponible à ce jour.

On connaît également de WO 07/027498, une structure pour cellule solaire (à base de Silicium) comportant une structure :
Verre / SnO₂ / SiO₂ / SnO₂:F (530-730nm) / TiO₂ (30-60 nm)

La couche de Ti02 permet de réduire la réflexion lumineuse de la structure, côté verre et ainsi augmenter la transmission lumineuse de la structure. Plus généralement, une couche ayant un indice entre 2.3 et 3.5 est requise pour optimiser la transmission lumineuse de l'empilage. La réflexion lumineuse obtenue, côté couche, est de 5.2 -8.0 %.

Toutefois cette structure ne convient pas pour une cellule de photoconversion à base de CdS / CdTe.

La présente invention a pour but de fournir une structure pour cellules solaires comportant un substrat en verre revêtu d'un empilage de couches qui combine à la fois des propriétés de conductibilité élevée et des propriétés optiques qui permettent d'améliorer le rendement des cellules solaires.

On a découvert qu'il est possible de fournir un substrat conducteur transparent qui combine à la fois les avantages de l'utilisation d'une couche tampon entre la couche conductrice et la cellule de photoconversion, tout en maintenant des propriétés de haute conductivité et des propriétés optiques qui permettent le meilleur rendement possible de la cellule de photoconversion.

La présente invention a pour objet un substrat transparent de type verrier revêtu d'un empilage de couches minces qui comporte au moins
i) une couche conductrice dont l'épaisseur est comprise entre 200 et 1000 nm
ii) une couche supérieure dont l'indice de réfraction est compris entre 1.45 et 2.2 et dont l'épaisseur est comprise entre 5 et 300 nm ;
le substrat et l'empilage étant tels que la valeur de Transmission entre 450 et 850 nm moins le haze est supérieure à 70 %, de préférence supérieure à 75%, 77% ou de manière encore préférée supérieure à voire 78%.

En particulier, l'objet de la présente invention est tel que défini dans les sous-revendications.

La couche conductrice est de préférence à base d'oxyde d'étain dopé au fluor et la couche supérieure est choisie, en particulier, parmi l'oxyde d'étain, l'oxyde de silicium, l'oxyde d'aluminium. Il est également possible d'avoir à la fois une couche à base d'oxyde d'étain et une couche additionnelle à base d'oxyde de silicium.
La couche supérieure lorsqu'elle est base d'oxyde d'étain, peut contenir des impuretés ou dopants, cependant sa quantité de dopants est alors avantageusement inférieure à la quantité de dopants de la couche conductrice. En particulier, le rapport entre le pourcentage de dopants dans la couche supérieure sur le pourcentage de dopants dans la couche conductrice est inférieur à 0.5, de préférence inférieur à 0.2, et de manière encore préférée inférieur à 0.1.
L'empilage comporte avantageusement une sous-couche située entre le substrat et la couche conductrice. Cette sous-couche a avantageusement un indice de réfraction (mesuré à 550 nm) compris entre 2.0 et 3.0, de préférence compris entre 2.2 et 2.7. En particulier, la sous-couche est à base de Ti02. Elle peut avoir une épaisseur comprise entre 4 et 30 nm, de préférence entre 5 et 20 et de manière encore préférée entre 7 et 16 nm. Son épaisseur optique (épaisseur X indice de réfraction) est avantageusement comprise entre 10 et 50 nm, de manière encore plus avantageuse entre 12 et 40 nm.
Pour obtenir une résistivité la plus faible possible, la couche conductrice a de préférence une épaisseur supérieure à 330 nm, de manière préférée supérieure à 400 nm et de manière encore plus préférée supérieure à 450 nm. Par contre pour des raisons optiques, la couche conductrice a de préférence une épaisseur inférieure à 700 nm, de préférence inférieure à 600 nm.
L'épaisseur de la couche supérieure est de préférence supérieure à 10 nm, de manière encore préférée supérieure à 20 nm et inférieure à 160 nm, de préférence inférieure à 100 nm.
En particulier, la transmission lumineuse (TLD65, 2°) du substrat revêtu est supérieure à 77% voire 78% et de préférence supérieure à 79 %.
Le substrat peut être un verre sodo-calcique clair ou extra-clair, en particulier un substrat dont la concentration en fer total est inférieure à 0.040 wt% Fe203, de manière préférée inférieure à 0.020 wt% Fe203, et de manière encore préférée inférieure à 0.015 wt% Fe203. Un substrat en verre peut aussi être caractérisé par sa transmission lumineuse et sa transmission solaire. Pour la présente invention, le substrat peut avantageusement être choisi parmi les substrats ayant une transmission lumineuse (TL, D65 - 4mm) supérieure à 90.0%, de préférence inférieure à 90.5% et de manière encore préférée inférieure à 91.0% ou parmi les substrats ayant une transmission solaire (TE EN410 - 4mm) supérieure à 86.5%, de préférence inférieure à 88.5%, et de manière encore préférée inférieure à 89.5%.
Le substrat revêtu selon l'invention présente avantageusement un haze le plus faible possible, en particulier inférieure à 5 %, de préférence inférieure à 2 %, de manière encore préférée inférieure à 1.5%.
Le substrat revêtu selon l'invention présente avantageusement une résistance de surface la plus faible possible, de préférence inférieure à 20 Ohms/carré, de manière encore préférée inférieure à 14 Ohms/carré, et de manière encore plus préférée inférieure à 12 Ohms/carré. Ceci pour limiter les pertes ohmiques. Une fois que les photons sont transformés en électrons par la cellule de photoconversion, le courant résultant peut ainsi circuler le plus librement possible avec le moins de perte ohmique possible.

Le substrat revêtu selon l'invention présente avantageusement un rapport (Transmission entre 450 et 850 nm moins haze) / résistance de surface (exprimée en Ohms/carré), supérieure à 6, de préférence supérieure à 6.5 et de manière encore préférée supérieure à 7.

D'autres couches peuvent être ajoutées, en particulier une couche intermédiaire entre la sous-couche et la couche conductrice. Celle-ci est par exemple à base de Si02 et peut présenter une épaisseur comprise entre 10 et 100 nm, de préférence entre 20 et 50 nm.
L'empilage peut comporter une couche supplémentaire, dont l'épaisseur peut être comprise entre 10 et 100 nm, de préférence entre 20 et 50 nm.

### Exemples :

### Exemple 1

Sur un ruban de verre float sodo-calcique extra clair (3.15 mm d'épaisseur, TL (D 65, 2°) = 90.9 %) est déposée par pyrolyse en phase gazeuse (CVD) une sous-couche de Ti02. Le précurseur utilisé est le « titanium tetraisopropoxide » (TTIP). La couche est déposée dans le caisson float lorsque le ruban de verre est à une température d'environ 660-700 °C.

Une seconde couche à base d'oxyde d'étain dopé au fluor est déposée sur la première couche, hors du caisson float, lorsque le ruban de verre est à une température d'environ 600-640 °C. Les précurseurs utilisés sont le « monobutyltin trichloride » (MBTC), l'acide fluorhydrique (HF) et de l'eau. Pour assurer une rugosité optimale, le rapport volumique MBTC/H2O est d'environ 1.3 et le rapport molaire d'environ 0.14.

Une troisième couche d'oxyde d'étain non dopé est déposée sur la couche conductrice, en tête de galerie de recuisson, lorsque le ruban de verre est à une température d'environ 550-600 ° C. Les précurseurs utilisés sont MBTC et de l'eau. Le rapport volumique MBTC/H2O est d'environ 2.

4 échantillons ont été réalisés selon cet exemple 1. Les propriétés optiques (transmission entre 450 et 850 nm, transmission lumineuse (mesurée sous illuminant D65, et angle solide d'observation de 2°), haze mesuré selon la norme D1003-95 (white light source) (Haze Garde type) et conductrice (résistance surfacique (« sheet resistance ») de l'empilage ont été mesurées. Le tableau ci-dessous reprend les résultats obtenus ainsi que les épaisseurs des différentes couches et les valeurs « T-H » (pourcentage de transmission entre 450 et 850 nm dont on a soustrait le pourcentage de haze) et « T-H/R » (résultat de la division de la valeur T-H par la résistance surfacique exprimée en ohm/carré).

### Exemple 2

*Le même empilage est réalisé qu'à l'exemple* 1 *mais le rapport volumique MBTC*/*H2O* de *la seconde couche est d'environ* 0.83 et le *rapport molaire* 0.09. *Les résultats sont également repris dans le tableau ci-dessous.*

### Exemple 3

*Le même empilage qu'à l'exemple* 1 *est réalisé mais le support est un verre clair normal (TL(D65, 2°)* = *-90.5%)* de *même épaisseur,* et le *rapport volumique MBTC*/*H2O* de *la seconde couche est d'environ* 0.56 et le *rapport molaire 0.06.*

Les échantillons de l'exemple 3 ont également subi un test de durabilité, du type « Damp Heat Bias » (DHB) qui permet de mesurer le risque de délamination des couches.

Ce test consiste à soumettre des échantillons revêtus de couches minces à une attaque électrique et thermique simultanée. Les échantillons de verre revêtus sont placés en étuve ou sur plaque chauffante et soumis à un champ électrique.

Les échantillons 3a à 3e ont été placés entre 2 électrodes, la face non revêtue posée sur une électrode en graphite (anode) et une électrode en cuivre recouverte d'aluminium (cathode) posée sur la face revêtue des échantillons. Les paramètres ont été réglés de la manière suivante : tension 200 Volts, température = 150°C, durée 15 min. Après passage des échantillons 1 h au cleavland *(condensing humidity, water temperature equals about* 55°C *and vapor temperature equals* 50°C +/-2°C), on mesure la surface de l'échantillon qui a pelé. Le tableau ci-dessous reprend le pourcentage de surface de l'échantillon revêtu qui a pelé.

| Ex. | TiO2 (nm) | SnO2 :F (nm) | SnO2 (nm) | T_{450- 850nm} (%) | *TL D65,2 °* *(%)* | Haze (%) | R (ohm / carré) | T-H (%) | *DHB* v*(%)* | *(T-H)* / *R* |
|---|---|---|---|---|---|---|---|---|---|---|
| 1a | 12 | 510 | 66 | 77.4 | 76.9 | 0.46 | 9.9 | 76.9 | | 7.8 |
| 1b | 12 | 480 | 66 | 78.1 | 77.9 | 0.36 | 10.6 | 77.7 | | 7.3 |
| 1c | 11 | 505 | 66 | 77.4 | 76.9 | 0.43 | 9.9 | 77.0 | | 7.8 |
| 1d | 12 | 545 | 66 | 76.6 | 77.2 | 0.48 | 8.9 | 76.1 | | 8.6 |
| 2a | 12 | 570 | 66 | 79.1 | 80.0 | 0.53 | 8.7 | 78.6 | | 9.0 |
| 2b | 11 | 530 | 47 | 79.5 | 79.7 | 0.91 | 10.0 | 78.6 | | 7.9 |
| *3a* | *13* | *560* | *47* | *77.8* | *79.4* | *0.60* | *9.5* | *77.2* | *0* | *8.2* |
| *3b* | 10 | *575* | *47* | *77.9* | *79.5* | *0.62* | *9.0* | *77.3* | *25* | *8.6* |
| *3c* | *13* | *560* | *47* | *77.6* | *79.0* | *0.65* | *8.8* | *76.9* | *0* | *8.7* |
| *3d* | *4* | *565* | *47* | *78.4* | *80.0* | *0. 72* | *9.2* | *77.7* | *35* | *8.4* |
| *3e* | *11* | *555* | *50* | *78.1* | *79.7* | *0.62* | *9.9* | 77.5 | *0* | 7.8 |

On constate de manière inattendue, que malgré l'épaisseur importante de la couche de Sn02 :F, et l'addition d'une couche tampon à base d'SnO2, le haze est maintenu à des valeurs très faibles et la transmission ente 450 et 850 nm reste assez élevée.

Ces empilages combinent donc de manière surprenante des propriétés électriques et optiques contradictoires : une conductivité électrique élevée, la présente d'une couche tampon apte à recevoir une cellule de photoconversion, en particulier CdS /CdTe et une transmission lumineuse et solaire élevée.

## Revendications

1. Substrat transparent de type verrier revêtu d'un empilage de couches minces qui comporte au moins
- une couche conductrice dont l'épaisseur est comprise entre 200 et 1000 nm
- une couche supérieure dont l'indice de réfraction est compris entre 1.45 et 2.2 et dont l'épaisseur est comprise entre 5 et 300 nm ;
le substrat et l'empilage étant tels que la valeur de Transmission entre 450 et 850 nm moins le haze est supérieure à 70 %.

2. Substrat revêtu selon la revendication 1, **caractérisé en ce que** la couche conductrice est à base d'oxyde d'étain dopé au fluor.

3. Substrat revêtu selon l'une quelconque des revendications précédentes, **caractérisé en ce que** la couche supérieure est choisie parmi l'oxyde d'étain, l'oxyde de silicium, l'oxyde d'aluminium.

4. Substrat revêtu selon l'une quelconque des revendications précédentes, **caractérisé en ce que** la couche supérieure est une couche l'oxyde d'étain dont le ratio de dopage par rapport à la couche conductrice est de maximum ½ et de préférence 1/5 et de préférence 1/10.

5. Substrat revêtu selon l'une quelconque des revendications précédentes, **caractérisé en ce que** la couche supérieure est une couche l'oxyde d'étain non dopée.

6. Substrat revêtu selon l'une quelconque des revendications précédentes, **caractérisé en ce que** l'empilage comporte une sous-couche.

7. Substrat revêtu selon la revendication précédente, **caractérisé en ce que** la sous-couche est à base d'un matériau dont l'indice de réfraction est compris entre 2.0 et 3.0, de préférence compris entre 2.2 et 2.7.

8. Substrat revêtu selon l'une quelconque des revendications 6 à 7, **caractérisé en ce que** la sous-couche est à base de Ti02.

9. Substrat revêtu selon l'une quelconque des revendications 6 à 8, **caractérisé en ce que** l'épaisseur de la sous-couche est comprise entre 4 et 30 nm, de préférence entre 5 et 14 et de manière encore préférée entre 6 et 12 nm.

10. Substrat revêtu selon l'une quelconque des revendications 6 à 9, **caractérisé en ce que** l'épaisseur optique de la sous-couche est comprise entre 10 et 50 nm, de préférence entre 12 et 40 nm.

11. Substrat revêtu selon l'une quelconque des revendications précédentes, **caractérisé en ce que** l'épaisseur de la couche conductrice est comprise entre 330 et 700 nm, de préférence entre 400 et 600 nm, et de manière encore préférée entre 450 et 600nm.

12. Substrat revêtu selon l'une quelconque des revendications précédentes, **caractérisé en ce que** l'épaisseur de la couche supérieure est comprise entre 10 et 160 nm, de préférence entre 20 et 100 nm.

13. Substrat revêtu selon l'une quelconque des revendications précédentes, **caractérisé en ce que** la transmission lumineuse est supérieure à 75%, de préférence supérieure à 77% et de manière encore préférée supérieure à 78%.

14. Substrat revêtu selon l'une quelconque des revendications précédentes, **caractérisé en ce que** le substrat est un verre sodo-calcique clair.
Substrat revêtu selon l'une quelconque des revendications 1 à 11, **caractérisé en ce que** le substrat est un verre sodo-calcique dont la concentration en fer total est inférieure à 0.040 wt% Fe₂O₃, de préférence inférieure à 0.020 wt% Fe₂O₃., et de manière encore préférée inférieure à 0.015 Fe₂O₃wt%.

15. Substrat revêtu selon l'une quelconque des revendications précédentes, **caractérisé en ce que** le haze est compris entre 0.0 et 5 %, de préférence entre 0.1 et 2 %, de manière encore préférée entre 0.2 et 1.5%.

16. Substrat revêtu selon l'une quelconque des revendications précédentes, **caractérisé en ce que** l'empilage présente une résistance de surface comprise entre 6 et 20 Ohms/carré, de préférence comprise entre 7 et 14 Ohms/carré, et de manière encore préférée comprise entre 8 et 12 Ohms/carré.

17. Substrat revêtu selon l'une quelconque des revendications 4 à 15, **caractérisé en ce qu'**il comporte une couche intermédiaire entre la sous-couche et la couche conductrice.

18. Substrat revêtu selon la revendication précédente, **caractérisé en ce que** la couche intermédiaire est à base de Si02.

19. Substrat revêtu selon l'une quelconque des revendications 16 et 17, **caractérisé en ce que** la couche intermédiaire a une épaisseur comprise entre 10 et 100 nm, de préférence entre 20 et 50 nm.

20. Substrat revêtu selon l'une quelconque des revendications précédentes, **caractérisé en ce qu'**il comporte une couche supplémentaire déposée sur la couche supérieure.

21. Substrat revêtu selon la revendication précédente, **caractérisé en ce que** la couche supplémentaire est à base de Si02.

22. Substrat selon l'une quelconque des revendications 19 et 20, **caractérisé en ce que** la couche supplémentaire à une épaisseur comprise entre 10 et 100 nm, de préférence entre 20 et 50 nm.

23. Substrat revêtu selon l'une quelconque des revendications précédentes tel que la Transmission entre 450 et 850 nm moins le haze est supérieure à 75 %, de manière préférée supérieure à 77 %, et de manière encore préférée supérieure à 78 %.

24. Substrat revêtu selon l'une quelconque des revendications précédentes, **caractérisé en ce que** le résultat de la division de (la Transmission entre 450 et 850 nm moins le haze) par la résistance de surface exprimée en Ohms/carré, est supérieure à 6, de préférence supérieure à 6.5 et de manière encore préférée supérieure à 7.

25. Substrat revêtu selon l'une quelconque des revendications précédentes, pour application d'une cellule de photo-conversion à base de CdS/CdTe.

26. Procédé de fabrication d'un substrat conducteur transparent constitué d'un substrat verrier revêtu d'un empilage de couches, **caractérisé par** les étapes suivantes :
a) on dépose par pyrolyse une couche conductrice à base d'SnO2 dopé au fluor en utilisant un mélange vaporisé des précurseurs suivantes : une source d'étain, une source de fluoré et de l'eau ; le rapport volumique source d'étain/eau étant compris entre 0.06 et 10, de préférence compris entre 0.1 et 5, de manière encore préférée compris entre 0.3 et 2.
b) on dépose par pyrolyse une couche supérieure à base d'oxyde d'étain en utilisant un mélange vaporisé d'une source d'étain et de l'eau ; le rapport volumique source d'étain/eau étant compris entre 0.6 et 4, de préférence compris entre 1 et 3.

27. Procédé selon la revendication précédente, **caractérisé en ce que** le précurseur d'étain est identique pour la couche conductrice et pour la couche supérieure.

28. Procédé selon l'une quelconque des revendications 25 et 26, **caractérisé en ce que** la source d'étain est choisie parmi les précurseurs d'étain organiques or organo-chlorés.
